# EUROPEAN PATENT APPLICATION

(11) **EP 4 752 933 A1**
(43) Date of publication of application: **03.06.2026**
(21) Application number: 24845872.1
(22) Date of filing: 10.07.2024
(51) Int. Cl.: H01L 21/67

(54) **HIGH-PRESSURE SUBSTRATE PROCESSING APPARATUS AND METHOD**

(30) Priority: 25.07.2023 KR 20230096533
(71) Applicant: HPSP Co., Ltd., Hwaseong-si, Gyeonggi-do 18449 (KR)
(72) Inventor: MIN, Bin Hong, Hwaseong-si, Gyeonggi-do 18449 (KR)
(74) Representative: von Bülow & Tamada
(86) International application number: PCT/KR2024/009807
(87) International publication number: WO 2025/023569

(57) **Abstract**

Disclosed are a high-pressure substrate processing apparatus and method. The high-pressure substrate processing apparatus comprises an inner chamber, an outer chamber, a heating module, and a circulation module. The inner chamber is formed so as to receive therein a substrate to be processed and a reactant gas supplied at a first pressure higher than atmospheric pressure. The outer chamber is provided with a receiving space for receiving the inner chamber therein. The receiving space is formed so as to receive therein a shielding gas supplied at a second pressure set in association with the first pressure. The heating module is formed so as to heat the reactant gas in order to process the substrate to be processed. The circulation module is provided with a duct communicating with the receiving space, and is formed so as to circulate a cooling gas along a closed loop-type circulation path. The closed loop-type circulation path passes through the heating module and the receiving space and continues on to the duct.

## Description

### [Technical Field]

The present disclosure relates to a processing apparatus and method used to process substrates at high pressure.

### [Background Art]

Typically, during a semiconductor device manufacturing process, various processes are performed on a semiconductor substrate. Examples of these processes include oxidation, nitriding, ion implantation, and deposition. Hydrogen or deuterium heat treatment is also used to improve the interface properties of semiconductor devices.

The gas used for substrate processing is supplied to the chamber at high pressure and acts on the semiconductor substrate. After processing is complete, the used gas is exhausted from the chamber. After the gas is exhausted, the processed wafer is removed from the chamber. Then, a new wafer and gas are supplied to the chamber for the next processing.

The chamber should have a certain level of sealing capability to prevent gas from leaking to the outside during the processing of the substrate. The sealing capability (and insulation) of the chamber is also important in preventing heat from leaking from within the chamber to the outside. However, the sealing capability may hinder lowering the temperature of the chamber.

Specifically, the temperature of the chamber should be lowered to remove the processed wafer after the processing is completed, but natural cooling takes a long time due to the sealing capability of the chamber. Therefore, there is a problem that the tact time of the processing for the wafer is lengthened.

The background technology described above is technical information that the inventor possessed for the purpose of deriving embodiments of the present disclosure or acquired during the derivation process, and cannot necessarily be said to be publicly known technology disclosed to the general public prior to the present application.

### [Disclosure]

### [Technical Problem]

An object of the present disclosure is to provide a high-pressure substrate processing apparatus and method that can cool a chamber more quickly than natural cooling through gas circulation between the inside and outside of a high-temperature chamber.

### [Technical Solution]

According to one aspect of the present disclosure for realizing the above-described object, a high-pressure substrate processing apparatus includes: an inner chamber configured to receive a substrate to be processed and a reaction gas supplied at a first pressure higher than atmospheric pressure; an outer chamber including a receiving space for receiving the inner chamber and formed to receive a protective gas supplied to the receiving space at a second pressure set relative to the first pressure; a heating module configured to heat the reaction gas for processing the substrate to be processed; and a circulation module including a duct communicating with the receiving space and formed to circulate a cooling gas along a closed-loop circulation path that passes through the heating module and the receiving space and extends to the duct.

Here, the cooling gas may be mixed with the protective gas to form a mixed gas, and flow along the closed-loop circulation path as part of the mixed gas.

Here, the duct may include one end connected to a lower portion of the outer chamber.

Here, the duct may further include the other end connected to an upper portion of the outer chamber.

Here, the circulation module may further include a communication valve configured to selectively cause the duct to communicate with the receiving space.

Here, the circulation module may further include a blower that circulates the cooling gas through the receiving space and the heating module to the duct.

Here, the high-pressure substrate processing apparatus may further include a gas supply module configured to supply the cooling gas to the duct at a third pressure set relative to the second pressure.

Here, the cooling gas may be an inert gas.

Here, the third pressure may be the same as the second pressure, or may be a pressure set within a range where related components are not impacted by a pressure difference with the second pressure when the outer chamber and the circulation module communicate with each other.

Here, the outer chamber may further include a partition plate that divides the receiving space into a high-temperature zone that receives the heating module and the inner chamber, and a low-temperature zone having a temperature lower than the high-temperature zone, and the closed-loop circulation path may include a section passing from the high-temperature zone to the low-temperature zone.
Here, the heating module may include a heater disposed in the receiving space so as to face the inner chamber, an insulating block having a through-hole and disposed to surround the heater, and the high-pressure substrate process apparatus may further include a blocking module configured to close the through-hole during operation of the heating module and open the through-hole during operation of the circulation module..

Here, the blocking module may include a shutter having an open hole corresponding to the through-hole, and a driving unit that moves the shutter between a first position in which the open hole is disposed offset from the through-hole and a second position in which the open hole is disposed corresponding to the through-hole.

According to another aspect of the present disclosure, a high-pressure substrate processing method includes: supplying a reaction gas at a first pressure higher than atmospheric pressure to an inner chamber in which a substrate to be processed is received; supplying a protective gas at a second pressure set relative to the first pressure to an outer chamber receiving the inner chamber; heating the reaction gas to a reaction temperature using a heating module so that the substrate to be processed is processed at the first pressure and the reaction temperature; supplying a cooling gas to a duct at a third pressure set relative to the second pressure; and communicating the duct with the outer chamber and circulating the cooling gas along a closed-loop circulation path passing through the duct, the heating module, and the outer chamber to cool the substrate.

Here, the supplying of the cooling gas to the duct at the third pressure set relative to the second pressure may include setting the third pressure to be equal to the second pressure.

Here, the heating of the reaction gas to the reaction temperature using the heating module so that the substrate to be processed is processed at the first pressure and the reaction temperature may include closing a through-hole formed in the heating module that heats the reaction gas to block the discharge of heat generated in the heating module through the through-hole, and the communicating of the duct with the outer chamber and the circulating of the cooling gas along the closed-loop circulation path connecting the duct and the outer chamber to cool the substrate may include opening the through-hole to allow the cooling gas to flow toward the inner chamber through the through-hole.

### [Advantageous Effects]

According to the high-pressure substrate processing apparatus and method according to the present disclosure configured as described above, the circulation module communicating with the outer chamber in a state where the reaction gas injected at high pressure into the inner chamber is heated by the heating module is formed to circulate cooling gas along the closed-loop circulation path passing through the receiving space of the outer chamber and the heating module, so that the cooling gas can cool the high-temperature inner chamber and, further, the substrate more quickly than natural cooling.

In addition, since an inert gas is used as the cooling gas, which is the same as the protective gas injected into the receiving space, even when the reaction gas leaks from the inner chamber into the receiving space, the risk of explosion of the reaction gas is structurally prevented.

### [BRIEF DESCRIPTION OF THE DRAWINGS]

FIG. 1 is a conceptual diagram of a high-pressure substrate processing apparatus according to one embodiment of the present disclosure.
FIG. 2 is a block diagram illustrating a control configuration of the high-pressure substrate processing apparatus of FIG. 1.
FIG. 3 is a conceptual diagram illustrating the high-pressure substrate processing apparatus of FIG. 1 in more detail.
FIG. 4 is a conceptual diagram illustrating the relationship between a shutter and an insulating block in a first position.
FIG. 5 is a conceptual diagram illustrating the relationship between the shutter and the insulating block in a second position.
FIG. 6 is a flowchart of a high-pressure substrate processing method according to another embodiment of the present disclosure.
FIG. 7 is a flowchart illustrating one step of FIG. 6 in more detail.
FIG. 8 is a flowchart illustrating a method for controlling a through-hole in relation to other steps of FIG. 6.

### [Best Mode]

Hereinafter, a preferred embodiment of the present disclosure will be described in detail with reference to the attached drawings.

The present disclosure is not limited to the embodiments disclosed below, but can be implemented in various forms and with various modifications. However, these embodiments are provided to ensure that the disclosure of the present disclosure is complete and to fully inform those skilled in the art of the scope of the disclosure. Therefore, the present disclosure is not limited to the embodiments disclosed below, but should be understood to include all modifications, equivalents, and substitutes included within the technical spirit and scope of the present disclosure, as well as substitutions or additions of the components of one embodiment with those of another embodiment.

The attached drawings are merely intended to facilitate understanding of the embodiments disclosed in this specification, and should not be construed as limiting the technical ideas disclosed in this specification, but should be understood to encompass all modifications, equivalents, and substitutes included within the spirit and technical scope of the present disclosure. In the drawings, the components may be expressed in exaggerated sizes or thicknesses for ease of understanding, but the scope of protection of the present disclosure should not be construed as being limited thereby.

The terminology used in this specification is only used to describe specific implementations or examples and is not intended to limit the present disclosure. In addition, the singular expression includes the plural expression unless the context clearly indicates otherwise. In the specification, terms such as "comprises" and "includes" are intended to indicate the presence of a feature, number, step, operation, component, part, or combination thereof described in the specification. In other words, it should be understood that terms such as "comprises" and "includes" do not exclude in advance the possibility of the presence or addition of one or more other features, numbers, steps, operations, components, parts, or combinations thereof.

Terms that include ordinal numbers, such as first, second, or the like, may be used to describe various components, but the components are not limited by these terms. These terms are used solely to distinguish one component from another.

When a component is referred to as being "coupled to/communicate with" or "connected" to another component, it should be understood that it may be directly coupled to/communicate with the other component, or that there may be other components in between. Conversely, when a component is referred to as being "directly coupled to", "directly communicating with", or "directly connected to" another component, it should be understood that there are no other components in between.

When a component is referred to as being "above" or "below" another component, it should be understood that it is not only positioned directly above the other component, but that there may also be other components intervening there.

Unless otherwise defined, all terms used herein, including technical or scientific terms, have the same meaning as commonly understood by one of ordinary skill in the art to which this disclosure pertains. Terms defined in commonly used dictionaries should be interpreted as having a meaning consistent with their meaning in the context of the relevant technology, and shall not be interpreted in an idealized or overly formal sense unless explicitly defined herein.

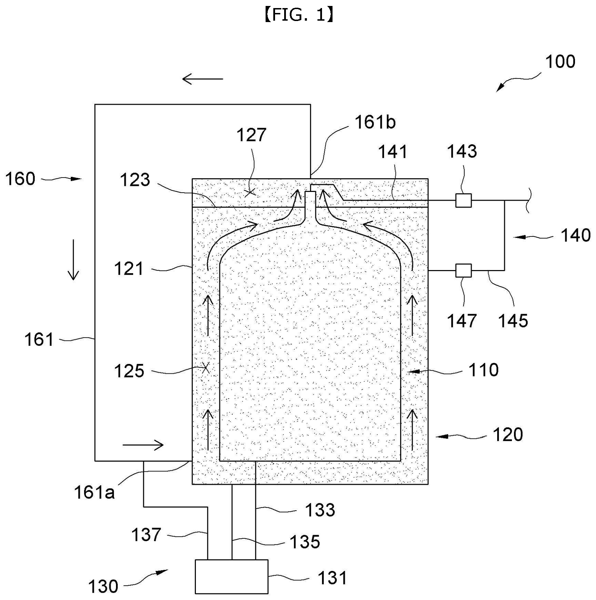

FIG. 1 is a conceptual diagram of a high-pressure substrate processing apparatus according to one embodiment of the present disclosure.

Referring to the drawing, a high-pressure substrate processing apparatus 100 may include an inner chamber 110, an outer chamber 120, a gas supply module 130, an exhaust module 140, and a circulation module 160.

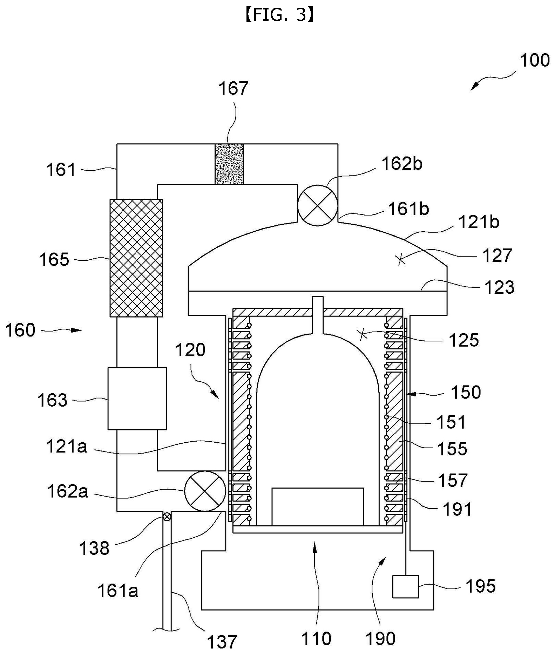

The inner chamber 110 forms a processing space where a substrate to be processed is processed. The inner chamber 110 may be made of a non-metallic material, for example, quartz, to reduce the possibility of generating contaminants (particles) in a high-temperature and high-pressure process environment. Although simplified in the drawing, an inner door (not illustrated) that opens the processing space is provided at the bottom of the body (inner housing) of the inner chamber 110. As the inner door is lowered, the processing space is opened, and the substrate may be placed into the inner chamber 110 in a state of being mounted on a holder (not illustrated). Depending on the operation of the heater 151 (refer to FIG. 3) disposed on the outside of the inner chamber 110, the temperature of the inner chamber 110 may reach several hundred degrees Celsius. The substrate may be, for example, a semiconductor wafer or display glass. In this case, the holder may be a wafer boat capable of stacking the semiconductor wafers in a plurality of layers.

The outer chamber 120 is configured to receive the inner chamber 110. Unlike the inner chamber 110, the outer chamber 120 is free from contamination issues regarding semiconductor wafers and may be manufactured from a metal material. The outer chamber 120 has an outer housing 121 having a receiving space for receiving the inner chamber 110. The outer housing 121 also has an outer door (not illustrated) at the bottom thereof, and the outer door may be lowered together with the inner door to open the receiving space. The inner chamber 110 may be mounted on the outer chamber 120.

The receiving space may be divided into two zones by a partition plate 123. The lower side of the partition plate 123 may be a high temperature zone 125 where the inner chamber 110 and the heater 151 are located. The upper side of the partition plate 123 may be a low temperature zone 127 having a lower temperature than the high temperature zone 125. The high temperature zone 125 has a temperature comparable to the inner chamber 110 depending on the operation of the heater 151, but the low temperature zone 127 may have a temperature significantly lower than the high temperature zone 125. Although the partition plate 123 divides the receiving space into the high temperature zone 125 and the low temperature zone 127, it is formed to allow a gas flow of less than a certain flow rate between them.

The gas supply module 130 is configured to supply gas to the chambers 110 and 120. The gas supply module 130 has a gas supply unit 131 communicating with a utility (gas supply facility) of a semiconductor factory. The gas supply unit 131 may selectively supply, as a reaction gas, for example, hydrogen gas H₂, deuterium gas D₂, fluorine gas F₂, ammonia gas NH₃, chlorine gas Cl₂, nitrogen gas N₂, or the like, to the inner chamber 110. The gas supply unit 131 may supply, as a protective gas, for example, nitrogen gas or argon gas Ar, which is an inert gas, to the outer chamber 120. The gas supply unit 131 may also supply, as a cooling gas, for example, the inert gas described above, to the circulation module 160. The reaction gas, protective gas, and cooling gas are respectively introduced into the inner chamber 110, the outer chamber 120, and the circulation module 160 through a reaction gas line 133, a protective gas line 135, and a cooling gas line 137. The protective gas introduced into the outer chamber 120 specifically fills the space between the outer chamber 120 and the inner chamber 110. The reaction gases, protective gases, and cooling gases may be collectively referred to as process gases since they are used in the processing.

The process gas may be supplied to form a high pressure higher than atmospheric pressure, for example, ranging from several atmospheres to several tens of atmospheres. In addition, when the pressure of the reaction gas is a first pressure, the pressure of the protective gas is a second pressure, and the pressure of the cooling gas is a third pressure, they may be maintained in a set relationship. For example, the second pressure may be set to be slightly greater than the first pressure. Such a pressure difference provides an advantage in that the reaction gas does not leak from the inner chamber 110. In addition, the third pressure may be the same as the second pressure, or a value within a set range for the second pressure. The set range may be, for example, 5 Psi or 10 Psi. Such a set range provides an advantage in that the related components are not impacted by the pressure difference between the second pressure and the third pressure when the outer chamber 120 and the circulation module 160 communicate with each other. The third pressure may also be determined at a level that does not significantly change the relationship between the second pressure and the first pressure. When the outer chamber 120 and the circulation module 160 communicate with each other, the cooling gas is mixed with the protective gas to form a new protective gas and a new second pressure. It is preferable that the new second pressure does not significantly deviate from the previously established relationship with the first pressure.

The exhaust module 140 is configured to exhaust the process gas from the chambers 110 and 120. To exhaust the reaction gas from the inner chamber 110, an exhaust pipe 141 is connected to the upper portion of the inner chamber 110. The exhaust pipe 141 is disposed in the low-temperature zone 127 and may extend from the low-temperature zone 127 to the outside of the outer chamber 120. A gas discharger 143 may be installed in the exhaust pipe 141. The gas discharger 143 may be a valve that controls the exhaust of the reaction gas.

In order to discharge the protective gas and the cooling gas from the outer chamber 120, an exhaust pipe 145 communicating with the outer chamber 120 and a gas discharger 147 installed therein may be provided. Since the exhaust pipes 141 and 145 communicate with each other, the reaction gas is diluted in the protective gas (and the cooling gas) and the concentration of the reaction gas is lowered before being discharged.

The circulation module 160 is configured to circulate the cooling gas along a closed-loop circulation path passing through the receiving space. The closed-loop circulation path includes the receiving space and a duct 161 communicating with the receiving space. One end 161a of the duct 161 may be connected to the lower portion of the outer chamber 120, specifically, to a side surface of the lower area. In contrast, the other end 161b of the duct 161 may be connected to the upper portion of the outer chamber 120, specifically, to the upper surface.

The closed-loop circulation path may generally form a rectangular closed loop. The closed-loop circulation path may be formed so that some sections thereof do not overlap with other sections. Within the receiving space, the closed-loop circulation path may include a section extending from the high-temperature zone 125 to the low-temperature zone 127.

The closed-loop circulation path is represented by arrows in this drawing. In the present embodiment, the cooling gas may flow in the direction of the arrows or counterclockwise. The cooling gas may be mixed with the protective gas during circulation to form a mixed gas, and may flow along the closed-loop circulation path as a part of the mixed gas.

According to this configuration, after heating the reaction gas to process the substrate, the circulation module 160 may be operated to cool the substrate. The circulation module 160 may cool the substrate by circulating the cooling gas or the mixed gas along the closed-loop circulation path. Specifically, the cooling gas removes heat from the inner chamber 110 or the reaction gas, thereby causing the substrate to be cooled as well. The operation of the circulation module 160 allows the substrate to be cooled more quickly than natural cooling.

In addition, since an inert gas is supplied as the cooling gas, even when the reaction gas leaks from the inner chamber 110 into the receiving space, the occurrence of a problem due to the reaction gas reacting with the cooling gas is structurally prevented.

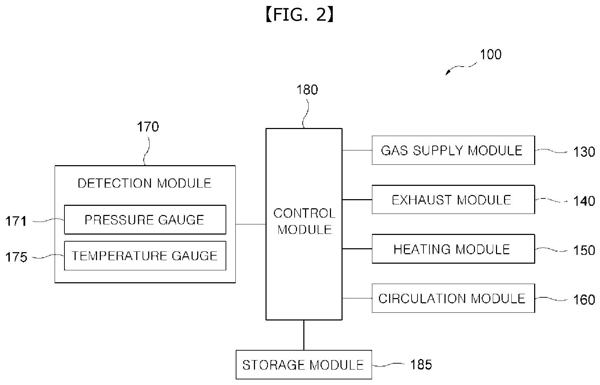

The control configuration of the high-pressure substrate processing apparatus 100 is described with reference to FIG. 2. FIG. 2 is a block diagram for explaining the control configuration of the high-pressure substrate processing apparatus 100 of FIG. 1.

Referring to this drawing (and FIG. 1), the high-pressure substrate processing apparatus 100 may further include, in addition to the gas supply module 130 described above, a heating module 150, a detection module 170, a control module 180, and a storage module 185.

The heating module 150 is configured to include the heater 151 mentioned above. The heater 151 heats the reaction gas to reach the reaction temperature.

The detection module 170 is configured to detect the environment of the chambers 110 and 120 and the circulation module 160. The detection module 170 may be equipped with a pressure gauge 171 and a temperature gauge 175. The pressure gauge 171 and the temperature gauge 175 may be installed in each of the chambers 110 and 120 and the duct 161 of the circulation module 160. The pressure gauge 171 may include a pressure gauge for measuring the pressure of each of the duct 161 and the receiving space, as well as a differential pressure gauge for measuring the pressure difference between the duct 161 and the receiving space.

The control module 180 is configured to control the gas supply module 130 and the exhaust module 140, or the like. The control module 180 may control the gas supply module 130, or the like, based on the detection result of the detection module 170.

The storage module 185 is configured to store data, programs, or the like that the control module 180 may reference for control. The storage module 185 may include at least one type of storage medium among flash memory, hard disk, magnetic disk, and optical disk.

According to this configuration, the control module 180 may control the operation of the gas supply module 130 based on the pressure (the first to third pressures) of the chambers 110 and 120 and the duct 161 obtained through the pressure gauge 171.

The control module 180 may also control the operation of the circulation module 160 based on the temperature of the chambers 110 and 120 obtained through the temperature gauge 175. The operation of the circulation module 160 may be performed when the above processing is completed.

When the processing is completed, the circulation module 160 may operate before the exhaust module 140 operates and the reaction gas is exhausted. Depending on the operation of the circulation module 160, the cooling gas or the mixed gas cools the reaction gas through heat exchange. When the third pressure is the same as the second pressure, the cooling process may be performed without fluctuations in the first pressure and the second pressure. The reaction gas may be exhausted by the exhaust module 140 while being cooled to below a set temperature. This enables preemptive removal of risk factors such as explosion that may occur as the reaction gas is exhausted at a high temperature. Unlike the above, the circulation module 160 may also operate simultaneously with the operation of the exhaust module 140.

The specific configuration of the circulation module 160 is described with reference to FIGS. 3 to 5.

FIG. 3 is a conceptual diagram illustrating the high-pressure substrate processing apparatus 100 of FIG. 1 in more detail. In this drawing, some components, such as the exhaust module 140, are not illustrated for the sake of simplicity.

Referring to this drawing, the (external) housing 121 of the outer chamber 120 may include a body portion 121a and a cover portion 121b. When the body portion 121a has a generally cylindrical shape, the cover portion 121b may have a shape corresponding to the open upper portion of the body portion 121a. The cover portion 121b may have a generally dome shape.

The partition plate 123 may be disposed to be spaced apart from the cover portion 121b in a state of facing the cover portion. The partition plate 123 is disposed on the lower side of the cover portion 121b in a state of being supported by the body portion 121a. The partition plate 123 may define the high-temperature zone 125 together with the body portion 121a, and define the low-temperature zone 127 together with the cover portion 121b.

The cover portion 121b and/or the partition plate 123 may be formed to receive a cooling medium, for example, cooling water, within the cover portion 121b and/or the partition plate 123. The cooling water received in the cover portion 121b and/or the partition plate 123 fills the low-temperature zone 127 with cold air. As a result, the temperature of the low-temperature zone 127 is maintained low. The cooling gas, the protective gas, or the mixed gas moved to the low-temperature zone 127 may be cooled through heat exchange with the cold air. As a result, the mixed gas and the like gain heat in the high-temperature zone 125, and then lose heat in the low-temperature zone 127.

The cooling gas line 137 of the gas supply module 130 is connected to the duct 161. The cooling gas line 137 may be connected between a first communication valve 162a and a blower 163. A shut-off valve 138 may be installed in the cooling gas line 137 to shut off the line.

The heating module 150 may further have an insulating block 155 in addition to the heater 151 described above. The heater 151 may have a shape that faces and surrounds the inner chamber 110. The insulating block 155 may be formed to surround the heater 151. For this purpose, the insulating block 155 may have an overall inverted cup shape. By the insulating block 155, the heat generated from the heater 151 may be mainly transferred toward the inner chamber 110 and may hardly be transferred toward the outer chamber 120. A through-hole 157 may be formed in the insulating block 155. The through-hole 157 may extend along a direction connecting the inner chamber 110 and the outer chamber 120. The through-hole 157 may be formed at the lower and upper portions of the insulating block 155. The through-holes 157 may also be formed at regular intervals along the periphery (circumference) of the insulating block 155. Since the cooling gas flows from the duct 161 toward the inner chamber 110 through the through-holes 157, the through-holes 157 may become a part of the closed-loop circulation path.

The circulation module 160 may further include, in addition to the duct 161 described above, a communication valves 162a and 162b, a blower 163, a cooler 165, and a filter 167.

The communication valves 162a and 162b are configured to selectively cause the duct 161 to communicate with the receiving space. The communication valves 162a and 162b may be divided into a first communication valve 162a installed at one end 161a and a second communication valve 162b installed at the other end 161b. The communication valves 162a and 162b may be opened when the circulation module 160 is operated and closed when the circulation module 160 is not operated.

The blower 163 is configured to cause the cooling gas to flow along the closed-loop circulation path. The blower 163 may be installed in a duct 161, specifically, so as to communicate with the closed-loop circulation path. By the operation of the blower 163, the cooling gas may start from the duct 161, pass through the receiving space and the heating module 150, and reach the duct 161.

The cooler 165 is configured to cool the mixed gas or the like circulating along the closed-loop circulation path. The cooler 165 may be installed in the duct 161 so as to communicate with the closed-loop circulation path. The mixed gas or the like may be further cooled by the cooler 165 after being cooled in the low-temperature zone 127. As the mixed gas or the like is cooled while circulating along the closed-loop circulation path, the heat of the inner chamber 110 can be more efficiently removed during the next circulation.

The filter 167 is configured to remove foreign substances of the mixed gas. The filter 167 may be located closer to the second communication valve 162b than to the cooler 165 or the blower 163.

The circulation module 160 may be constructed by combining the above configurations in various ways, and some configurations may not be adopted as needed. For example, when sufficient cooling of the mixed gas is achieved in the low-temperature zone 127, the cooler 165 may not be adopted.

Depending on whether the circulation module 160 is operated, the through-hole 157 may be opened or closed. To open/close the through-hole 157, a blocking module 190 may be provided.

The blocking module 190 is configured to close the through-hole 157 when the circulation module 160 is not operated (when the heating module 150 is operated). Conversely, the blocking module 190 is configured to open the through-hole 157 when the circulation module 160 is operated (when the chamber is cooled). Specifically, the blocking module 190 may include a shutter 191 and a driving unit 195.

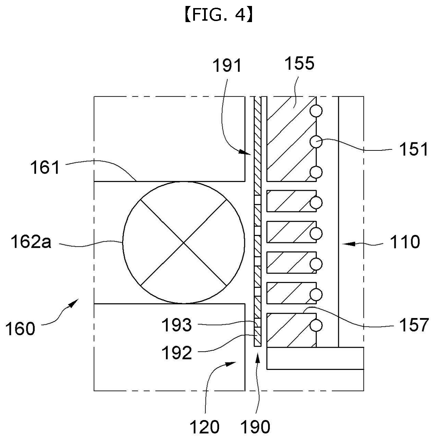

The shutter 191 is disposed between the outer chamber 120 and the insulating block 155. The shutter 191 may have a cylindrical body 192 surrounding the insulating block 155. An open hole 193 (refer to FIG. 4) may be perforated in the cylindrical body 192. The open hole 193 may be formed to correspond to the through-hole 157.

The driving unit 195 is configured to drive the shutter 191 and move the shutter 191 between a first position and a second position. To this end, the driving unit 195 may include a hydraulic/pneumatic cylinder, a linear motor, or the like that enables linear driving.

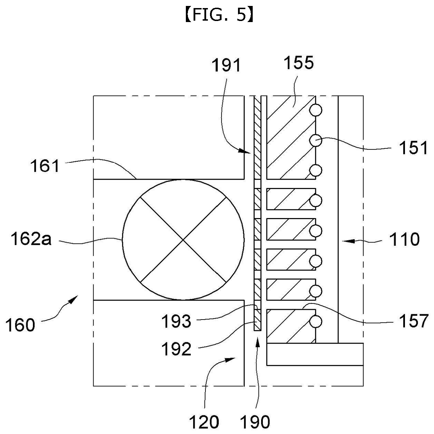

The specific configuration of the blocking module 190 is further explained with reference to FIGs. 4 and 5. FIG. 4 is a conceptual diagram illustrating the relationship between the shutter 191 and the insulating block 155 at the first position, and FIG. 5 is a conceptual diagram illustrating the relationship between the shutter 191 and the insulating block 155 at the second position.

Referring to FIG. 4, the open hole 193 in the first position is disposed to be offset from the through-hole 157. This arrangement places the through-hole 157 in a closed state. This state is suitable when the heating module 150 is operated and the circulation module 160 is not operated. The heat generated in the heating module 150 remains within the space surrounded by the insulating block 155 and does not escape to the outside of the space along the through-hole 157.

Referring to FIG. 5, the open hole 193 in the second position is disposed to correspond to the through-hole 157. This arrangement places the through-hole 157 in an open state. This state is suitable when the heating module 150 is not operated and the circulation module 160 is operated. By the operation of the circulation module 160, the cooling gas may flow into the space surrounded by the insulating block 155 through the open hole 193 and the through-hole 157. Thereby, the cooling gas may exchange heat with the inner chamber 110 and remove heat from the inner chamber 110.

To switch between the first position and the second position, the driving unit 195 may push the shutter 191 upwards or pull the shutter downwards along the height direction. Alternatively, the driving unit 195 may also rotate the shutter 191 along the circumferential direction of the shutter 191 to realize the switching.

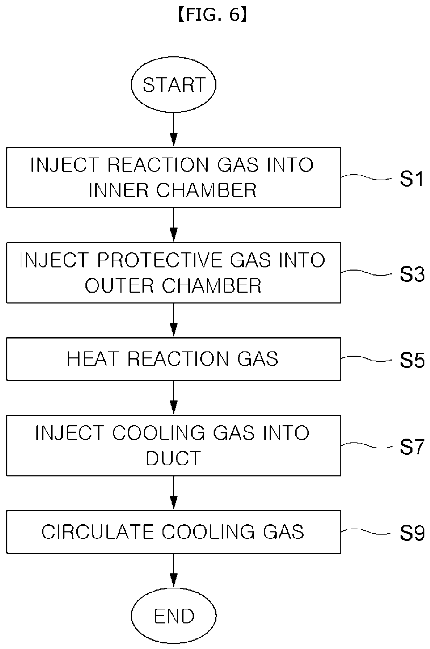

Next, the operation of the high-pressure substrate processing apparatus 100 will be described with reference to FIGS. 6 to 8.

FIG. 6 is a flowchart of a high-pressure substrate processing method according to another embodiment of the present disclosure.

Referring to this drawing (and FIGS. 1 to 5), for processing the substrate, the control module 180 controls the gas supply module 130 to inject the reaction gas into the inner chamber 110, specifically, the processing space (S1). The reaction gas is injected to reach the reaction pressure (first pressure).

The gas supply module 130 injects the protective gas into the outer chamber 120, specifically, the receiving space (S3). The protective gas is injected to reach a pressure (second pressure) according to the set relationship with the reaction gas.

The control module 180 operates the heating module 150 to heat the reaction gas (S5). When the reaction gas reaches the reaction temperature, the substrate is processed at the reaction temperature and the reaction pressure.

After the processing is completed, the circulation module 160 may be operated to rapidly cool the inner chamber 110, more specifically, the substrate. To this end, the control module 180 controls the gas supply module 130 to inject the cooling gas into the duct 161 (S7).

The control module 180 causes the duct 161 to communicate with the receiving space so that the cooling gas circulates along the closed-loop circulation path (S9). In this case, the cooling gas may flow along the closed-loop circulation path in a state of being mixed with the protective gas. Depending on the operation of the exhaust module 140, in a state where a portion of the mixed gas is exhausted, the remainder may circulate along the closed-loop circulation path. In this case, the mixed gas may have a lower pressure than before the operation of the exhaust module 140.

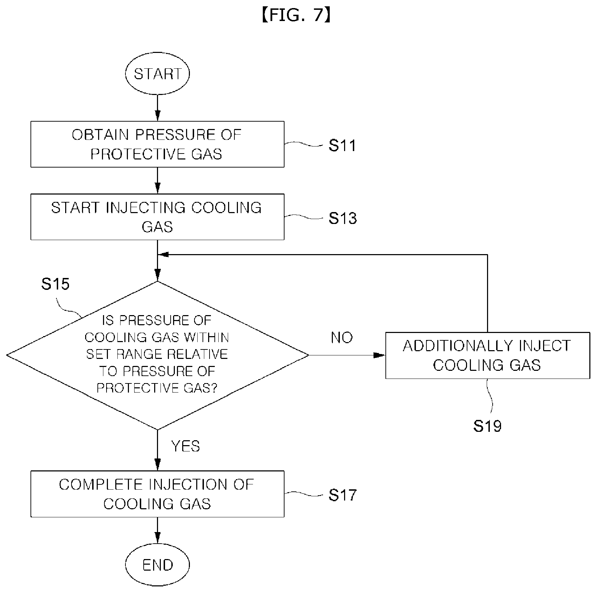

FIG. 7 is a flowchart illustrating the step (S7) of FIG. 6 in more detail.

Referring further to this drawing, the control module 180 obtains the pressure of the protective gas, that is, the second pressure, for injection of the cooling gas (S11). The second pressure may be detected through a pressure gauge 171.

The control module 180 causes the supply module 130 to start injecting the cooling gas with the goal of reaching the third pressure (S13).

The control module 180 determines whether the third pressure is within a set range relative to the second pressure (S15). Here, the third pressure may be the same value as the second pressure. Alternatively, the second pressure and third pressure may have a certain level of pressure difference. The pressure difference between the receiving space and the duct 161 may be detected by the differential pressure gauge.

When the third pressure is within the set range, the control module 180 controls the gas supply module 130 to complete the injection of the cooling gas (S17). Otherwise, the gas supply module 130 will additionally inject the cooling gas into the duct 161 (S19).

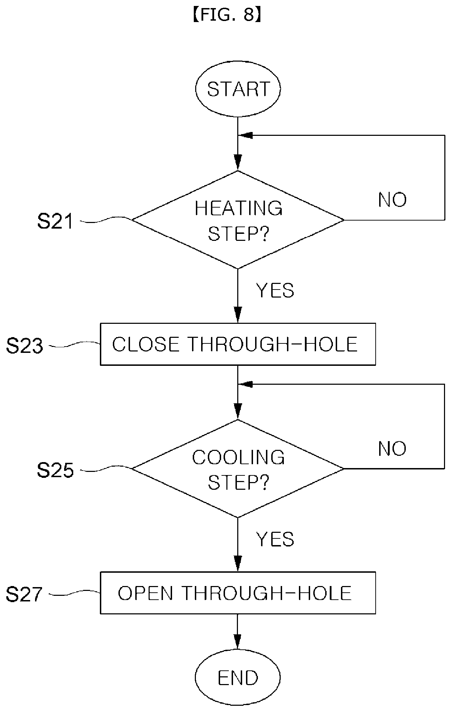

FIG. 8 is a flowchart illustrating a method of controlling the through-hole 157 in relation to other steps (S5 and S9) of FIG. 6.

Referring further to this drawing, the control module 180 determines whether the processing process for the substrate has reached the heating step (S21).

In the heating step, the control module 180 operates the heating module 150 and also operates the blocking module 190 (S23). The control module 180 operates the blocking module 190 to close the through-hole 157 (S23). The heat for heating the reaction gas is not discharged to the outside through the through-hole 157.

The control module 180 determines whether the processing of the substrate has been completed and has reached a step where cooling is required (S25).

In the cooling step, the control module 180 controls the circulation module 160 to cause the duct 161 to communicate with the receiving space and operates the blocking module 190. The control module 180 operates the blocking module 190 to open the through-hole 157. As a result, the cooling gas can flow along the closed-loop circulation path passing through the heating module 150 through the through-hole 157.

In the present specification, the high-pressure substrate processing apparatus 100 having the dual chamber (inner chamber 110 and outer chamber 120) has been described as an example, but the present disclosure is not limited thereto. The configuration of the circulation module 160 and the like can also be applied to a semi-dual chamber, which is an intermediate form between a single chamber and the dual chamber. The semi-dual chamber may have two housings (an inner housing and an outer housing) and one door. The two housings may correspond to the inner housing and the outer housing 121 of the previous embodiment. The two housings may be combined by their own shapes or by interposing a separate member interposed therebetween to form a closed space (corresponding to the receiving space). Similar to the previous embodiment, the substrate may be placed in the processing space of the inner housing and the reaction gas may be injected, and the protective gas may be injected into the closed space. Unlike the previous embodiments, the door is not protected by the protective gas. The door may correspond to the outer door of the previous embodiment. The door may open and close the inner housing (and the outer housing). In the present specification, the high-pressure substrate processing apparatus 100 is described as a batch type processing device, but the present disclosure is not limited thereto. The present disclosure may also be applied to a single wafer type processing device.

### [Industrial Applicability]

The present disclosure has industrial applicability in the field of manufacturing a high-pressure substrate processing apparatus.

## Claims

1. A high-pressure substrate processing apparatus comprising:
an inner chamber configured to receive a substrate to be processed and a reaction gas supplied at a first pressure higher than atmospheric pressure;
an outer chamber including a receiving space for receiving the inner chamber and formed to receive a protective gas supplied to the receiving space at a second pressure set relative to the first pressure;
a heating module configured to heat the reaction gas for processing the substrate to be processed; and
a circulation module including a duct communicating with the receiving space and formed to circulate a cooling gas along a closed-loop circulation path that passes through the heating module and the receiving space and extends to the duct.

2. The high-pressure substrate processing apparatus of claim 1, wherein the cooling gas is mixed with the protective gas to form a mixed gas, and flows along the closed-loop circulation path as part of the mixed gas.

3. The high-pressure substrate processing apparatus of claim 1, wherein the duct includes one end connected to a lower portion of the outer chamber.

4. The high-pressure substrate processing apparatus of claim 3, wherein the duct includes the other end connected to an upper portion of the outer chamber.

5. The high-pressure substrate processing apparatus of claim 1, wherein the circulation module further includes a communication valve configured to selectively cause the duct to communicate with the receiving space.

6. The high-pressure substrate processing apparatus of claim 1, wherein the circulation module further includes a blower that circulates the cooling gas through the receiving space and the heating module to the duct.

7. The high-pressure substrate processing apparatus of claim 1, further comprising a gas supply module configured to supply the cooling gas to the duct at a third pressure set relative to the second pressure.

8. The high-pressure substrate processing apparatus of claim 1, wherein the cooling gas is an inert gas.

9. The high-pressure substrate processing apparatus of claim 7, wherein the third pressure is the same as the second pressure, or is a pressure set within a range where related components are not impacted by a pressure difference from the second pressure when the outer chamber and the circulation module communicate with each other.

10. The high-pressure substrate processing apparatus of claim 1, wherein the outer chamber further includes a partition plate that divides the receiving space into a high-temperature zone that receives the heating module and the inner chamber, and a low-temperature zone having a temperature lower than the high-temperature zone, and
the closed-loop circulation path includes a section passing from the high-temperature zone to the low-temperature zone.

11. The high-pressure substrate processing apparatus of claim 1, wherein the heating module further includes
a heater disposed in the receiving space so as to face the inner chamber,
an insulating block having a through-hole and disposed to surround the heater, and
the high-pressure substrate process apparatus further includes a blocking module configured to close the through-hole during operation of the heating module and open the through-hole during operation of the circulation module.

12. The high-pressure substrate processing apparatus of claim 11, wherein the blocking module includes
a shutter having an open hole corresponding to the through-hole, and
a driving unit that moves the shutter between a first position in which the open hole is disposed offset from the through-hole and a second position in which the open hole is disposed corresponding to the through-hole.

13. A high-pressure substrate processing method comprising:
supplying a reaction gas at a first pressure higher than atmospheric pressure to an inner chamber in which a substrate to be processed is received;
supplying a protective gas at a second pressure set relative to the first pressure to an outer chamber receiving the inner chamber;
heating the reaction gas to a reaction temperature using a heating module so that the substrate to be processed is processed at the first pressure and the reaction temperature;
supplying a cooling gas to a duct at a third pressure set relative to the second pressure; and
communicating the duct with the outer chamber and circulating the cooling gas along a closed-loop circulation path passing through the duct, the heating module, and the outer chamber to cool the substrate.

14. The high-pressure substrate processing method of claim 13, wherein the supplying of the cooling gas to the duct at the third pressure set relative to the second pressure includes setting the third pressure to be equal to the second pressure.

15. The high-pressure substrate processing method of claim 13, wherein the heating of the reaction gas to the reaction temperature using the heating module so that the substrate to be processed is processed at the first pressure and the reaction temperature includes closing a through-hole formed in the heating module that heats the reaction gas to block the discharge of heat generated in the heating module through the through-hole, and
the communicating of the duct with the outer chamber and the circulating of the cooling gas along the closed-loop circulation path connecting the duct and the outer chamber to cool the substrate includes opening the through-hole to allow the cooling gas to flow toward the inner chamber through the through-hole.
